(19) Europäisches Patentamt
European Patent Office
Office européen des brevets

(11) **EP 3 199 962 A1**

(12) **EUROPÄISCHE PATENTANMELDUNG**

(43) Veröffentlichungstag:
02.08.2017 Patentblatt 2017/31

(51) Int Cl.:
*G01R 31/34* *(2006.01)*

(21) Anmeldenummer: 16153104.1

(22) Anmeldetag: 28.01.2016

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft**
**80333 München (DE)**

(72) Erfinder:
• **Getschmann, Thorsten**
**10553 Berlin (DE)**
• **Heidenreich, Daniel**
**14641 Selbelang (DE)**

(54) **TESTVERFAHREN FÜR EINE ELEKTRISCHE ROTIERENDE MASCHINE**

(57) Die Erfindung betrifft ein Verfahren zum Testen des thermischen und/oder mechanischen Verhaltens einer elektrischen rotierenden Maschine (1) mit einem um eine Rotationsache (4) rotierbaren Rotor (3) und einem Stator (2). Um das Verfahren ohne die Umgebungsbedingungen in einer Anlage und ohne eine Arbeitsmaschine durchführen zu können, wird vorgeschlagen, dass in einem ersten Schritt der Rotor (3) in eine negative Drehrichtung (6) durch ein, insbesondere vom Stator (2) generiertes, negatives Drehfeld (8) auf eine negative erste Drehzahl (n1) beschleunigt wird, wobei der Rotor (3) in einem darauf folgenden Schritt zumindest bis zu einer negativen zweiten Drehzahl (n2) auslaufen gelassen wird, wobei in einem darauf folgenden Schritt ein positives Drehfeld (9) mit einer zweiten Frequenz (f2) zugeschaltet wird, wobei der Rotor (3) durch das Zuschalten des positiven Drehfeldes (9) auf eine positive dritte Drehzahl (n3) beschleunigt wird und wobei eine Größe gemessen wird, welche das thermische und/oder mechanische Verhaltens der elektrischen rotierenden Maschine (1) beschreibt.

FIG 1

**Beschreibung**

Die Erfindung betrifft ein Verfahren zum Testen des thermischen und/oder mechanischen Verhaltens einer elektrischen rotierenden Maschine mit einem um eine Rotationsache rotierbaren Rotor und einem Stator.

Die Erfindung betrifft weiterhin ein Testsystem zum Testen des thermischen und/oder mechanischen Verhaltens einer elektrischen rotierenden Maschine mit einem derartigen Verfahren.

Beim asynchronen Anlauf einer elektrischen rotierenden Maschine, insbesondere Motor oder Generator, mit Drehstromanschluss, beispielsweise eine Synchronmaschine oder eine Asynchronmaschine, welcher auch DOL-Anlauf genannt wird, wobei DOL für "direct on line" steht, wird eine bestimmte Wärmemenge in den Rotor der elektrischen rotierenden Maschine eingeprägt. Diese Wärmemenge kommt durch Ströme im Rotor zustande und ist vom Trägheitsmoment der Anlage, dem Gegenmoment sowie der Netzbeschaffenheit abhängig. Derartige Randbedingungen einer vollständigen Anlage stehen im Prüffeld nicht zur Verfügung. Das Gegenmoment in der Anlage verursacht beispielsweise eine sogenannte Arbeitsmaschine, beispielsweise eine Pumpe, wobei die elektrische rotierende Maschine möglicherweise in geringer Stückzahl für eine spezielle Anwendung mit einer beispielsweise schwer verfügbaren Arbeitsmaschine hergestellt wird.

Trotz des Nachteils der hohen Wärmeentwicklung im Rotor, insbesondere bei elektrischen rotierenden Maschinen mit einer Leistung von mindestens einem Megawatt, wird diese Anlaufmethode, bevorzugt bei elektrischen rotierenden Maschinen, welche mit einer festen Drehzahl betrieben werden, häufig verwendet, da sie, beispielsweise durch den Wegfall eines ausschließlich für den Anlauf erforderlichen Anlaufumrichters, kostengünstig und einfach in der Durchführung ist.

Das Verhalten der elektrischen rotierenden Maschine beim asynchronen Anlauf, insbesondere das thermische und mechanische Verhalten, kann bisher nur bei der Inbetriebnahme in der Anlage, beispielsweise mit einer Arbeitsmaschine, welche ein Lastmoment erzeugt, getestet und untersucht werden.

Ein Verfahren zum Testen und Beurteilen der mechanischen und thermischen Beanspruchung durch den asynchronen Anlauf bereits im Werk würde es ermöglichen, insbesondere die Einhaltung von Schwingungsgrenzwerten und Temperaturgrenzwerten während und nach dem Anlauf zu überprüfen. Eventuell erforderliche Maßnahmen können dann noch im Werk durchgeführt werden, was Zeit und Kosten einspart. Weiterhin kann gegenüber dem Kunden vorab der Nachweis erbracht werden, dass die Maschine die in sie gestellten Anforderungen erfüllt.

Der Erfindung liegt die Aufgabe zugrunde, ein Verfahren zum Testen des thermischen und/oder mechanischen Verhaltens einer elektrischen rotierenden Maschine mit einem um eine Rotationsache rotierbaren Rotor und einem Stator anzugeben, welches ohne die Randbedingungen in einer vollständigen Anlage, insbesondere ohne eine Arbeitsmaschine, durchführbar ist.

Die Aufgabe wird erfindungsgemäß durch ein Verfahren der eingangs genannten Art gelöst, wobei in einem ersten Schritt der Rotor in eine negative Drehrichtung durch ein, insbesondere vom Stator generiertes, negatives Drehfeld auf eine negative erste Drehzahl beschleunigt wird, wobei der Rotor in einem darauf folgenden Schritt zumindest bis zu einer negativen zweiten Drehzahl auslaufen gelassen wird, wobei in einem darauf folgenden Schritt ein positives Drehfeld mit einer zweiten Frequenz zugeschaltet wird, wobei der Rotor durch das Zuschalten des positiven Drehfeldes auf eine positive dritte Drehzahl beschleunigt wird und wobei eine Größe gemessen wird, welche das thermische und/oder mechanische Verhaltens der elektrischen rotierenden Maschine beschreibt.

Im ersten Schritt kann der Rotor beispielsweise durch ein vom Stator generiertes Drehfeld oder von einem Anwurfmotor, welcher auch Ponymotor genannt wird, beschleunigt werden, wobei bei einem Anwurfmotor kein Restfeld bestehen bleibt. Die elektrische rotierende Maschine kann beispielsweise durch das Trennen von einer Spannungsversorgung auslaufen gelassen werden. Durch das neue Verfahren kann die gleiche Wärmemenge auch ohne die Randbedingungen einer vollständigen Anlage in die Rotoroberfläche eingeprägt werden. So kann die elektrische rotierende Maschine mit einer vergleichbaren thermischen und mechanischen Belastung bereits im Prüffeld beaufschlagt werden. Dadurch ist es möglich, Messungen an der elektrischen rotierenden Maschine, beispielsweise in einem Prüffeld, ohne eine daran angekoppelte Arbeitsmaschine durchzuführen. Beispielsweise wird das Vibrationsverhalten des Rotors mit Hilfe eines Abstandssensors an der Rotorwelle in einem Lager gemessen. Ein derartiges Verfahren ist vorteilhaft, da so die Einhaltung von Grenzwerten, beispielsweise von Schwingungsgrenzwerten während und nach dem Anlauf, noch im Werk überprüft werden kann, was Zeit und Kosten einspart. Gegenüber den Kunden kann vorab der Nachweis erbracht werden, dass die elektrische rotierende Maschine die an sie gestellten Anforderungen erfüllt.

Die Aufgabe wird weiterhin durch ein Testsystem zum Prüfen des thermischen und/oder mechanischen Verhaltens einer elektrischen rotierenden Maschine mit einem derartigen Verfahren gelöst, wobei das Testsystem eine Spannungsversorgung für die elektrische rotierende Maschine, einen Umrichter, welcher dafür geeignet ist, den Rotor im ersten Schritt auf eine Schleuderdrehzahl zu beschleunigen und/oder synchron zu beschleunigen und ein Computersystem, welches Mittel zur Steuerung der elektrischen rotierenden Maschine, der Spannungsversorgung und/oder des Umrichters aufweist, aufweist. Dadurch kann die elektrische rotierende Maschine bereits im Werk, beispielsweise direkt nach der Fertigung, überprüft werden, was Zeit und Kosten einspart. Insbesondere wenn ein Fehler, beispielsweise ein Produktionsfehler, vorliegt, kann die elektrische rotierende Maschine direkt vor Ort repariert werden. Weiterhin wird durch ein derartiges Testsystem die Fehlersuche im Fehlerfall erleichtert, da nur die elektrische rotierende Maschine mit wenigen zusätzlichen und potentiell fehleranfälligen Komponenten getestet wird.

Mit Hilfe eines derartigen Testsystems ist es möglich, Messungen an der elektrischen rotierenden Maschine, insbesondere für einen asynchronen Anlauf, ohne eine daran angekoppelte Arbeitsmaschine, beispielsweise in einem Prüffeld, durchzuführen.

Bevorzugt wird der Rotor im ersten Schritt synchron auf die negative erste Drehzahl beschleunigt. Dies führt zu genaueren Ergebnissen bei der Messung, da sich im Rotor so keine oder sehr wenig Wirbelströme, welche zu einer Erhöhung der Temperatur auf dem Rotor führen, ausbilden.

In einer bevorzugten Ausführungsform entspricht die negative erste Drehzahl zumindest näherungsweise einer Schleuderdrehzahl der elektrischen rotierenden Maschine. Die Schleuderdrehzahl ist bevorzugt das 1,2fache der Bemessungsdrehzahl. Bei einer Maschine, welche beispielsweise mit einer festen Frequenz von 50 Hz gespeist wird, was einer exemplarischen Bemessungsdrehzahl von 1500 Umdrehungen pro Minute entspricht, ist die Schleuderdrehzahl 1800 Umdrehungen pro Minute. Dies ist vorteilhaft, da mit einem derartigen Verfahren ein Nachweis über die Funktionalität der elektrischen rotierenden Maschine bevorzugt nach einer Norm, beispielsweise IEC60034, NEMA MG1 oder VDE 0530, erbracht werden kann.

Besonders vorteilhaft wird die negative zweite Drehzahl zumindest näherungsweise aus einer bei einem Anlauf in einer Anlage in den Rotor eingebrachten Energie $Q_A$, aus einem Trägheitsmoment $J_M$ des Rotors in der Anlage und aus einer Bemessungsdrehzahl $n_B$ der elektrischen rotierenden Maschine berechnen, wobei die Parameter $Q_A$, $J_M$ und $n_B$ empirisch und/oder analytisch ermittelt werden. Beispielsweise wird die negative zweite Drehzahl nach folgender Formel berechnet:

$$n_2 = \left( \sqrt{\frac{Q_A}{\frac{1}{2} J_M \cdot \omega_B^2}} - 1 \right) \cdot n_B$$

Eine derartige analytische und/oder empirische Ermittlung der Rahmenbedingungen in einer Anlage ist vorteilhaft, da auf diese Weise die Ergebnisse des Testverfahrens einer vollständigen Anlagenmessung sehr nahe kommen.

Bei einer bevorzugten Ausführungsform entspricht die positive dritte Drehzahl zumindest näherungsweise einer Bemessungsfrequenz, wobei sich der Rotor beim Erreichen der positiven dritten Drehzahl synchron zum positiven Drehfeld bewegt. Die Bemessungsfrequenz entspricht bevorzugt der Netzfrequenz, beispielsweise 50 Hz oder 60 Hz. Der synchrone Betrieb bei der festen Bemessungsfrequenz entspricht dem stationären Betrieb der Anlage, für den kein Umrichter erforderlich ist. Die Prüfung bei synchroner Drehzahl liefert realistische Messwerte.

Vorteilhaft wird das positive Drehfeld erst zugeschaltet, wenn zusätzlich ein Restfeld abgeklungen ist. Bevorzugt wird das Restfeld durch eine Spannungsmessung an den Statorklemmen gemessen. Das Abklingen des Restfeldes kann beispielsweise durch Anlegen eines Drehfeldes mit reduzierter Spannung in Gegenrichtung beschleunigt werden.

Bevorzugt wird spätestens nach dem Erreichen der positiven dritten Drehzahl des Rotors eine Temperatur auf dem Rotor gemessen und/oder eine Schwingungsmessung durchgeführt. Eine Temperatur auf dem Rotor, insbesondere auf der Rotoroberfläche, wird beispielsweise mit einem berührungslosen Temperatursensor ermittelt. Eine Schwingungsmessung wird bevorzugt mit Hilfe von Abstandssensoren durchgeführt. Dies ist vorteilhaft, da so ein Nachweis erbracht werden kann, dass die Maschine die spezifizierten Anforderungen erfüllt.

Im Folgenden wird die Erfindung anhand der in den Figuren dargestellten Ausführungsbeispiele näher beschrieben und erläutert.

Es zeigen:

FIG 1    einen Querschnitt einer elektrischen rotierenden Maschine, welche in negative Drehrichtung betrieben wird,

FIG 2    einen Querschnitt einer elektrischen rotierenden Maschine, welche in positive Drehrichtung betrieben wird,

FIG 3    eine schematische Darstellung des zeitlichen Ablaufs der Drehzahl der elektrischen rotierenden Maschine in Zusammenhang mit der Frequenz des Drehfeldes und

FIG 4    ein Blockschaltbild eines Testsystems.

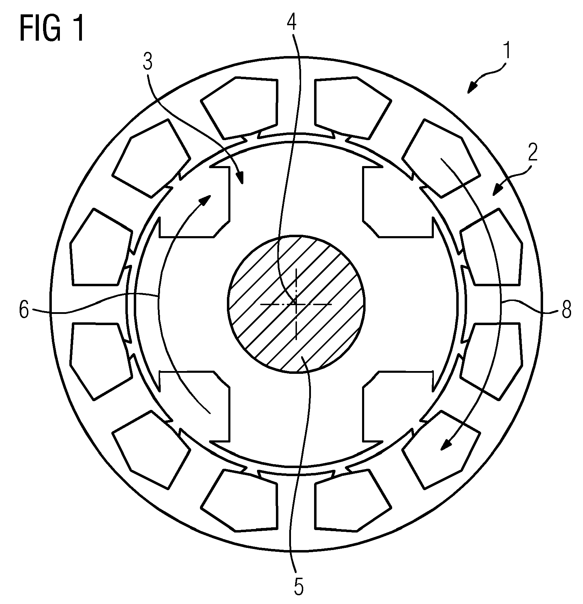

FIG 1 zeigt einen Querschnitt einer elektrischen rotierenden Maschine 1, welche in negative Drehrichtung 6 betrieben wird. Die elektrische rotierende Maschine 1 ist exemplarisch als Synchronmaschine mit Schenkelpolläufer ausgeführt, weist einen um eine Rotationsache 4 rotierbaren Rotor 3 und einen Stator 2 auf. Der Rotor 3 weist eine Welle 5 auf. Die Spulen im Rotor 3 und im Stator 2 sind aus Gründen der Übersichtlichkeit nicht dargestellt.

Im Stator 2 wird ein negatives Drehfeld 8 erzeugt, welches sich exemplarisch im Uhrzeigersinn dreht und dessen Frequenz kontinuierlich, beispielsweise linear, steigt. Durch das negative Drehfeld 8 wird der Rotor 3 in negative Drehrichtung 6 synchron auf eine negative erste Drehzahl n1, welche zumindest näherungsweise der Schleuderdrehzahl der elektrischen rotierenden Maschine 1 entspricht, beschleunigt. Die Schleuderdrehzahl ist das 1,2fache der Bemessungsdrehzahl der elektrischen rotierenden Maschine 1. Die Bemessungsdrehzahl der elektrischen rotierenden Maschine 1 ist hier die Drehzahl, bei der die elektrische rotierende Maschine 1 betrieben wird. Wird die elektrische rotierende Maschine 1 bei mehreren Drehzahlen betrieben, ist die Bemessungsdrehzahl die höchste Drehzahl, bei der die elektrische rotierende Maschine 1 betrieben wird. Die synchrone Beschleunigung der elektrischen rotierenden Maschine 1 auf die Schleuderdrehzahl entspricht einer Ausführungsform des ersten Schrittes des erfindungsgemäßen Verfahrens zum Testen des thermischen und/oder mechanischen Verhaltens einer elektrischen rotierenden Maschine 1.

Nach dem Erreichen der Schleuderdrehzahl wird die elektrische rotierende Maschine 1 von ihrer Spannungsversorgung getrennt und der Rotor 3 wird bis zu einer negativen zweiten Drehzahl n2 auslaufen gelassen.

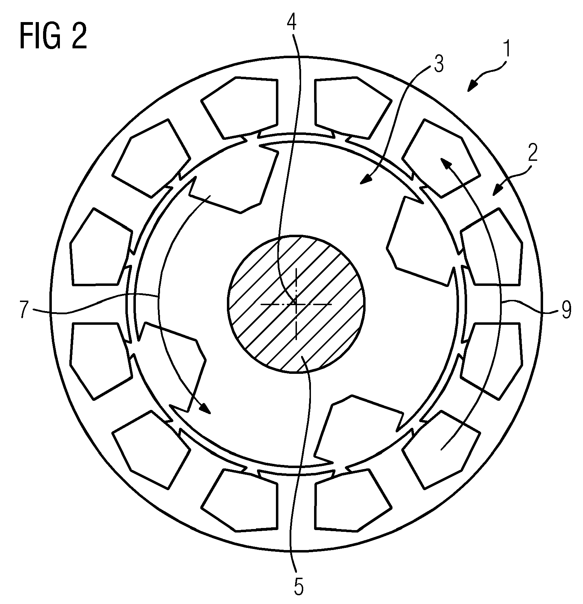

FIG 2 zeigt einen Querschnitt einer elektrischen rotierenden Maschine 1, welche in positive Drehrichtung 7 betrieben wird. Im Stator 2 wird ein positives Drehfeld 9 erzeugt, welches sich in Gegenrichtung zum in FIG 1 dargestellten negativen Drehfeld 8 gegen den Uhrzeigersinn dreht. Die übrige Ausführung der elektrischen rotierenden Maschine 1 entspricht der aus FIG 1.

Das zu dem negativen Drehfeld 8 gegensinnige positive Drehfeld 9 wird während des Verfahrens zum Testen des thermischen und/oder mechanischen Verhaltens der elektrischen rotierenden Maschine 1 dann zugeschaltet, wenn eine negative zweite Drehzahl n2 erreicht oder unterschritten ist. Die negative zweite Drehzahl n2 berechnet sich nach folgender Formel:

$$n_2 = \left( \sqrt{\frac{Q_A}{\frac{1}{2} J_M \cdot \omega_B^2}} - 1 \right) \cdot n_B$$

$Q_A$ ist hierbei die in den Rotor 3 bei einem Anlauf auf der Anlage eingebrachte Energie. $J_M$ ist das Trägheitsmoment des Rotors 3, welches ein optionales zusätzliches Trägheitsmoment beinhaltet, und $n_B$ ist die Bemessungsdrehzahl der elektrischen rotierenden Maschine 1, wobei $\omega_B$ der synchronen Winkelgeschwindigkeit der Bemessungsdrehzahl entspricht. Die Parameter aus der Formel können empirisch oder analytisch ermittelt werden.

Weiterhin wird das positive Drehfeld 9 erst zugeschaltet, wenn zusätzlich das Restfeld im Stator 2 abgeklungen ist. Nach dem Zuschalten des positiven Drehfeldes 9 bremst der Rotor 3 bis auf Drehzahl Null ab und beschleunigt dann in seiner vorgesehenen positiven Drehrichtung 7 bis zur synchronen positiven dritten Drehzahl n3.

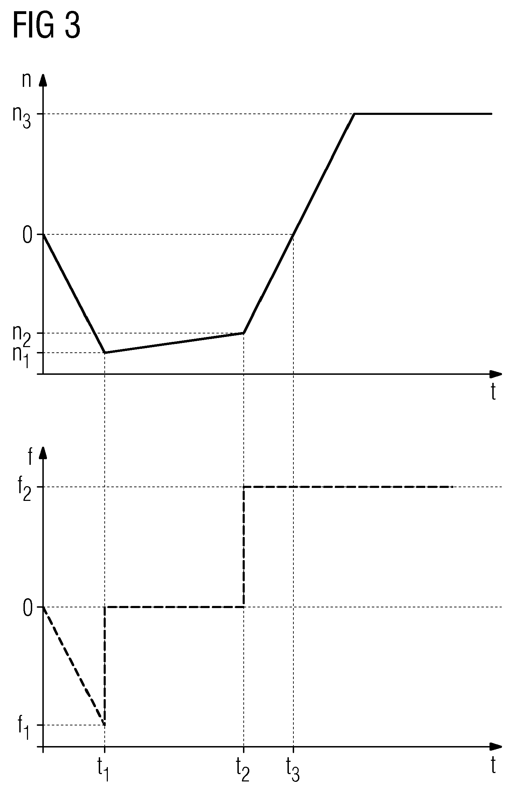

FIG 3 zeigt eine schematische Darstellung des zeitlichen Ablaufs der Drehzahl n der elektrischen rotierenden Maschine 1 in Zusammenhang mit der Frequenz f des Drehfeldes. Das negative Drehfeld 8 wird mit einer exemplarisch linear abfallenden Frequenz im Bereich von 0 Hz bis zu einer negativen ersten Frequenz f1 angeregt, sodass der Rotor 3 bis zu einem ersten Zeitpunkt t1 auf eine negative erste Drehzahl n1 beschleunigt wird. Die Frequenz ist deshalb negativ, da ein negatives Drehfeld angeregt wird, welches entgegen der Drehrichtung des Rotors 3 während des Normalbetriebes rotiert.

Nach dem Erreichen der negativen ersten Drehzahl n1 wird die elektrische rotierende Maschine 1 von ihrer Spannungsversorgung getrennt und der Rotor 3 wird bis zu einer negativen zweiten Drehzahl n2 zu einem Zeitpunkt t2 auslaufen gelassen. Die negative zweite Drehzahl n2 berechnet sich nach der oben genannten Formel, welche von der bei einem Anlauf in einer Anlage in den Rotor 3 eingebrachten Energie $Q_A$, vom Trägheitsmoment des belasteten Rotors 3 $J_M$ und von der Bemessungsdrehzahl $n_B$ der elektrischen rotierenden Maschine 1 abhängt. Zusätzlich wird das positive Drehfeld 9 erst zugeschaltet, wenn das Restfeld im Stator 2 abgeklungen ist. Zum Zeitpunkt t2 wird daraufhin ein positives Drehfeld 9 mit einer positiven zweiten Frequenz f2 in Gegenrichtung des bisherigen negativen Drehfeldes 8 angeregt. Nach dem Zuschalten des positiven Drehfeldes 9 bremst der Rotor 3 bis zu einem dritten Zeitpunkt t3 auf Drehzahl Null ab und beschleunigt dann bis zur synchronen positiven dritten Drehzahl n3. Das Abbremsen und Beschleunigen auf die dritte Drehzahl n3 ist aus Gründen einer einfacheren Darstellung linear dargestellt.

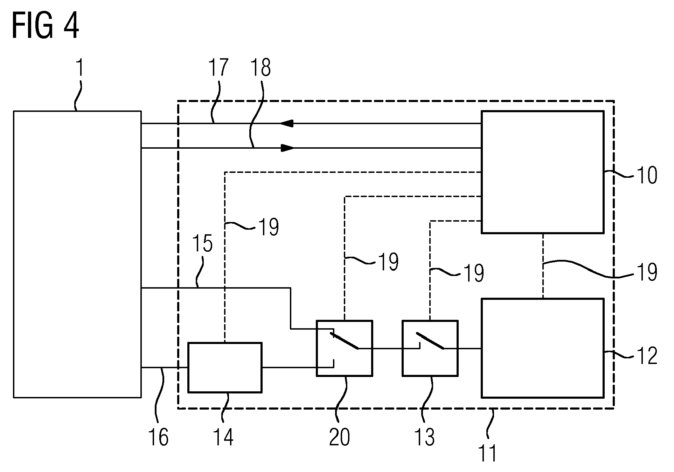

FIG 4 zeigt ein Blockschaltbild eines Testsystems 11, welches zum Prüfen des thermischen und/oder mechanischen Verhaltens einer elektrischen rotierenden Maschine 1 geeignet ist. Das Testsystem 11 weist eine Spannungsversorgung 12 für die elektrische rotierende Maschine 1, einen Umrichter 14, eine Schaltvorrichtung 13, eine Umschaltvorrichtung 20 und ein Computersystem 10 auf. Das Computersystem 10 ist über Steuerleitungen 19 mit der Spannungsversorgung 12, dem Umrichter 14, der Schaltvorrichtung 13 und der Umschaltvorrichtung 20 verbunden und kann diese über die Steuerleitungen 19 ansteuern. Mit Hilfe der Schaltvorrichtung 13, welche vom Computersystem 10 gesteuert wird, lässt sich die Spannungsversorgung 12 zu- und abschalten. Mit Hilfe der Umschaltvorrichtung 20 wird der Umrichter 14 zugeschaltet, falls man die elektrische rotierende Maschine 1 beispielsweise auf eine Schleuderdrehzahl beschleunigen und/oder synchron beschleunigen möchte. So kann die elektrische rotierende Maschine 1 direkt von der Spannungsversorgung 12 näherungsweise mit einer konstanten Frequenz oder vom Umrichter 14 mit einer variablen Frequenz gespeist werden.

Weiterhin ist das Computersystem 10 mit der elektrischen rotierenden Maschine 1 über eine erste Schnittstelle 17 und eine zweite Schnittstelle 18 verbunden. Über die Schnittstellen 17, 18 können bidirektional Daten und Steuerbefehle übertragen werden. Beispielsweise können Sensordaten von der elektrischen rotierenden Maschine 1 zum Computersystem 10 und/oder Steuerbefehle in die umgekehrte Richtung übertragen werden. Die Daten- und Steuerleitungen 17, 18, 19 können als parallele oder serielle Schnittstellen ausgeführt sein. Das Computersystem kann von einem übergeordneten System, beispielsweise einem Zentralrechner gesteuert werden und die Daten können einem Netzwerk zur weiteren Auswertung zur Verfügung gestellt werden. Die Erfassung der Messwerte, wie Schwingungen oder Temperaturen, kann auch in einem separaten Computersystem erfolgen.

Zusammenfassend betrifft die Erfindung ein Verfahren zum Testen des thermischen und/oder mechanischen Verhaltens einer elektrischen rotierenden Maschine 1 mit einem um eine Rotationsache 4 rotierbaren Rotor 3 und einem Stator 2. Um das Verfahren ohne die Umgebungsbedingungen in einer Anlage und ohne eine Arbeitsmaschine durchführen zu können, wird vorgeschlagen, dass in einem ersten Schritt der Rotor 3 in eine negative Drehrichtung 6 durch ein, insbesondere vom Stator 2 generiertes, negatives Drehfeld 8 auf eine negative erste Drehzahl n1 beschleunigt wird, wobei der Rotor 3 in einem darauf folgenden Schritt zumindest bis zu einer negativen zweiten Drehzahl n2 auslaufen gelassen wird, wobei in einem darauf folgenden Schritt ein positives Drehfeld 9 mit einer zweiten Frequenz f2 zugeschaltet wird, wobei der Rotor 3 durch das Zuschalten des positiven Drehfeldes 9 auf eine positive dritte Drehzahl n3 beschleunigt wird und wobei eine Größe gemessen wird, welche das thermische und/oder mechanische Verhaltens der elektrischen rotierenden Maschine 1 beschreibt.

## Patentansprüche

1. Verfahren zum Testen des thermischen und/oder mechanischen Verhaltens einer elektrischen rotierenden Maschine (1) mit einem um eine Rotationsache (4) rotierbaren Rotor (3) und einem Stator (2), wobei in einem ersten Schritt der Rotor (3) in eine negative Drehrichtung (6), insbesondere durch ein vom Stator (2) generiertes negatives Drehfeld (8), auf eine negative erste Drehzahl (n1) beschleunigt wird, wobei der Rotor (3) in einem darauf folgenden Schritt zumindest bis zu einer negativen zweiten Drehzahl (n2) auslaufen gelassen wird, wobei in einem darauf folgenden Schritt ein positives Drehfeld (9) mit einer zweiten Frequenz (f2) zugeschaltet wird, wobei der Rotor (3) durch das Zuschalten des positiven Drehfeldes (9) auf eine positive dritte Drehzahl (n3) beschleunigt wird und wobei eine Größe gemessen wird, welche das thermische und/oder mechanische Verhaltens der elektrischen rotierenden Maschine (1) beschreibt.

2. Verfahren nach Anspruch 1, wobei der Rotor (3) im ersten Schritt synchron auf die negative erste Drehzahl (n1) beschleunigt wird.

3. Verfahren nach einem der Ansprüche 1 oder 2, wobei die negative erste Drehzahl (n1) zumindest näherungsweise einer Schleuderdrehzahl der elektrischen rotierenden Maschine (1) entspricht.

4. Verfahren nach einem der Ansprüche 1 bis 3, wobei die negative zweite Drehzahl (n2) zumindest näherungsweise aus einer bei einem Anlauf in einer Anlage in den Rotor (3) eingebrachten Energie $Q_A$, aus einem Trägheitsmoment $J_M$ des Rotors (3) in der Anlage und aus einer Bemessungsdrehzahl $n_B$ der elektrischen rotierenden Maschine (1) berechnet wird, wobei die Parameter $Q_A$, $J_M$ und $n_B$ empirisch und/oder analytisch ermittelt werden.

5. Verfahren nach einem der Ansprüche 1 bis 4, wobei die positive dritte Drehzahl (n3) zumindest näherungsweise einer Bemessungsfrequenz entspricht und wobei sich der Rotor (3) beim Erreichen der positiven dritten Drehzahl (n3) synchron zum positiven Drehfeld (9) bewegt.

6. Verfahren nach einem der Ansprüche 1 bis 5, wobei das positive Drehfeld (9) erst zugeschaltet wird, wenn zusätzlich ein Restfeld abgeklungen ist.

7. Verfahren nach einem der Ansprüche 1 bis 6, wobei spätestens nach dem Erreichen der positiven dritten Drehzahl (n3) des Rotors (3) eine Temperatur auf dem Rotor (3) gemessen wird und/oder eine Schwingungsmessung durchgeführt wird.

8. Testsystem (11) zum Prüfen des thermischen und/oder mechanischen Verhaltens einer elektrischen rotierenden Maschine (1) mit einem Verfahren nach einem der Ansprüche 1 bis 7, aufweisend eine Spannungsversorgung (12) für die elektrische rotierende Maschine (1), einen Umrichter (14), welcher dafür geeignet ist, den Rotor (3) im ersten Schritt auf eine Schleuderdrehzahl zu beschleunigen und/oder synchron zu beschleunigen und ein Computersystem (10), welches Mittel zur Steuerung der elektrischen rotierenden Maschine (1), der Spannungsversorgung (12) und/oder des Umrichters (14) aufweist.

FIG 1

FIG 2

# FIG 3

FIG 4

**Europäisches Patentamt**
**European Patent Office**
**Office européen des brevets**

# EUROPÄISCHER RECHERCHENBERICHT

Nummer der Anmeldung

EP 16 15 3104

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 577 137 B1 (FISHER JAMES ALLAN [US]) 10. Juni 2003 (2003-06-10) * Spalte 1, Zeilen 38-48; Anspruch 20 * ----- | 1-8 | INV. G01R31/34 |
| A | BABAU R ET AL: "Complete Parameter Identification of Large Induction Machines From No-Load Acceleration-Deceleration Tests", IEEE TRANSACTIONS ON INDUSTRIAL ELECTRONICS, IEEE SERVICE CENTER, PISCATAWAY, NJ, USA, Bd. 54, Nr. 4, 1. August 2007 (2007-08-01), Seiten 1962-1972, XP011187456, ISSN: 0278-0046, DOI: 10.1109/TIE.2007.895080 * das ganze Dokument * ----- | 1-8 | |
| A | US 4 204 425 A (MALLICK GEORGE T JR [US]) 27. Mai 1980 (1980-05-27) * Spalte 1, Zeile 48 - Spalte 2, Zeile 6 * ----- | 1-8 | |

**RECHERCHIERTE SACHGEBIETE (IPC)**

G01R
H02K

Der vorliegende Recherchenbericht wurde für alle Patentansprüche erstellt

| Recherchenort | Abschlußdatum der Recherche | Prüfer |
|---|---|---|
| München | 30. Juni 2016 | Dogueri, Ali Kerem |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**　　EP 16 15 3104

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-06-2016

| Im Recherchenbericht angeführtes Patentdokument | Datum der Veröffentlichung | Mitglied(er) der Patentfamilie | Datum der Veröffentlichung |
|---|---|---|---|
| US 6577137 B1 | 10-06-2003 | KEINE | |
| US 4204425 A | 27-05-1980 | CA 1121458 A<br>US 4204425 A | 06-04-1982<br>27-05-1980 |

Für nähere Einzelheiten zu diesem Anhang : siehe Amtsblatt des Europäischen Patentamts, Nr.12/82

EPO FORM P0461